# EUROPÄISCHE PATENTSCHRIFT

(11) **EP 1 233 278 B1**
(45) Veröffentlichungstag und Bekanntmachung des Hinweises auf die Patenterteilung: **18.10.2006**
(21) Anmeldenummer: 02405046.0
(22) Anmeldetag: 28.01.2002
(51) Int. Cl.: G01R 31/34

(54) **Vorrichtung zur Generatordiagnose bei eingebautem Rotor**
Device for diagnosing a generator with mounted rotor
Dispositif de diagnostic d'un générateur à rotor monté

(30) Priorität: 14.02.2001 DE 10107401
(43) Veröffentlichungstag der Anmeldung: 21.08.2002
(73) Patentinhaber: Alstom Technology Ltd, 5400 Baden (CH)
(72) Erfinder: Häusermann, Peter, 5605 Dottikon (CH); Kirchhoff, Ingo, 5454 Bellikon (CH); Mark, Bernhard, 79761 Waldshut-Tiengen (DE); Stutz, Peter, 5611 Anglikon (CH)

(56) Entgegenhaltungen:
- EP-A- 0 684 483
- US-A- 4 901 572
- US-A- 5 252 927
- US-A- 6 100 711
- PATENT ABSTRACTS OF JAPAN vol. 016, no. 067 (E-1168), 19. Februar 1992 (1992-02-19) -& JP 03 261351 A (TOSHIBA CORP), 21. November 1991 (1991-11-21)

## Beschreibung

### TECHNISCHES GEBIET

Die vorliegende Erfindung betrifft eine Vorrichtung zur Generatordiagnose bei eingebautem Rotor, welche Informationen über an den Maschinenluftspalt zwischen Stator und Rotor grenzende Bestandteile zu übermitteln in der Lage ist. Des weiteren betrifft die Erfindung ein Verfahren zur Diagnose eines Generators, insbesondere zur Diagnose betreffend an den Maschinenluftspalt zwischen Stator und Rotor grenzende Bestandteile des Generators.

### STAND DER TECHNIK

Im Umgang mit Generatoren spielt die gezielte Überwachung des Gesamtzustandes eines Generators eine grosse Rolle. Um Standzeiten infolge defekter Bestandteile zu verhindern oder um Entscheidungsgrundlagen bei der Erneuerung oder teilweisen Erneuerung von Generatoren zur Verfügung zu stellen, müssen deshalb Generatoren periodisch in vielerlei Hinsicht untersucht werden. Ausfallzeiten durch derartige Bestandsaufnahmen sollen dabei so gering wie möglich sein, d.h. die Inspektionen sollten ohne große Demontagearbeiten und ohne langen Untersuchungs- und Datenerfassungsaufwand einfach möglich sein.

Insbesondere die Untersuchung vom sogenannten Maschinenluftspalt, dem Zwischenraum zwischen unbeweglichem Stator und bei Betrieb rotierendem Rotor ist dabei wichtig und sollte möglichst ohne aufwendigen Ausbau des Rotors aus dem Stator möglich sein.

Bei der Untersuchung des Maschinenluftspaltes geht es dabei darum, einerseits durch visuelle Verfahren Informationen über den Windungsschluss der Rotorwicklung, die Blechpaketenden, den Zustand der in der Statorbohrung sichtbaren Teile wie z.B. Nutkeile und Blechung, Rotoroberfläche einschliesslich Verkeilung und Kappen etc. zu gewinnen.

Andererseits wird durch andere Messverfahren eine Zustandserfassung der an den Luftspalt angrenzenden Komponenten durchgeführt mit folgenden Schwerpunkten: Statornutverkeilung, Statorblechpaket, Blechkurzschlüsse. Das Verfahren zur Bewertung des Zustandes der Statorverkeilung basiert beispielsweise auf einem System, das mit festgelegter Stärke die Keile abklopft und die resultierenden Schwingungen registriert. Der Zustand des Statorblechpaketes wird mit Hilfe eines Verfahrens erfasst, das auf der Messung des Nut-Streuflusses basiert, welcher sich beim Vorliegen von Kurzschlüssen verändert. Der Nut-Streufluss wird durch Ringmagnetisierung (Niederinduktion) des Blechpaketes erzeugt. Durch Aufzeichnen des Streuflussbildes der Blechzähne werden so eventuelle Kurzschlüsse lokalisiert.

Die Untersuchung des Maschinenluftspaltes bei eingebautem Rotor erfolgt nach dem Stand der Technik meist indem Vorrichtungen auf dem auf der Rotorwelle sitzenden Ventilator, am Statorgehäuse oder am Stator befestigt werden, welche das Einführen von Inspektionssonden in den Spalt in kontrollierter Weise ermöglichen. Infolge unterschiedlicher Geometrie von Ventilatoren, Statoren und Statorgehäusen bei verschiedenen Generatoren müssen aber beim Einbau derartiger Vorrichtungen häufig grosse Anpassungen der Vorrichtung an die generatorseitigen Gegebenheiten durchgeführt werden.

Aus der JP 03261351 A ist eine Vorrichtung zur Untersuchung von an einen Maschinenluftspalt zwischen Stator und Rotor grenzenden Bestandteilen eines Generators bei eingebautem Rotor mittels wenigstens einer beweglichen Inspektionssonde bekannt, wobei die Vorrichtung eine an den Rotorkappen befestigte Basiseinheit umfasst, welche Basiseinheit es erlaubt, eine Inspektionssonde im Maschinenluftspalt sowohl in bezüglich der Generatorachse axialer als auch in Umfangsrichtung des Maschinenluftspaltes über den Umfang des Rotors zu bewegen. Dazu ist die Basiseinheit mit auf der Oberfläche der Rotorkappen fest aufliegenden Zahnriemen verbunden und wird an diesen Zahnriemen über den Umfang der Rotorkappen bewegt. Ähnliche, beidseitig des Rotors befestigte Vorrichtungen sind auch aus der US-A-5252927 und der EP-A-0684483 bekannt.

### DARSTELLUNG DER ERFINDUNG

Der Erfindung liegt demnach die Aufgabe zugrunde, eine Vorrichtung zur Untersuchung von an einen Maschinenluftspalt zwischen Stator und Rotor grenzenden Bestandteilen eines Generators bei eingebautem Rotor mittels wenigstens einer beweglichen Inspektionssonde zur Verfügung zu stellen, welches sich einfach und schnell bei Generatoren unterschiedlichster Bauweise und Dimensionierung installieren lässt, und bei welchem die Inspektionssonde im gesamten Maschinenluftspalt bewegt werden kann, um alle Bereiche untersuchen zu können.

Die Lösung dieser Aufgabe wird dadurch erreicht, dass die vorgeschlagene Vorrichtung eine Basiseinheit umfasst, welche es erlaubt, die wenigstens eine Inspektionssonde im Maschinenluftspalt sowohl in bezüglich der Generatorachse axialer als auch in Umfangsrichtung des Maschinentuftspaltes über den vollen Umfang des Rotors zu bewegen.

Dazu Kann die Basiseinheit an den endseitig am Rotor angebrachten Rotorkappen befestigt werden. Insbesondere die Rotorkappen, welche meist eine einfache glatte zylindrische Form aufweisen sind bei allen Generatoren im wesentlichen bis auf die Dimensionierung gleich und eignen sich dadurch besonders für die Befestigung der Vorrichtung. Insbesondere wenn die Basiseinheit der Vorrichtung zwei Endteile umfasst, welche an den Rotorkappen befestigt werden, und wenn zwischen den Endteilen wenigstens ein, vorzugsweise aber zwei Tragseile angeordnet sind, an welchen die wenigstens eine Inspektionssonde in axialer Richtung im Maschinenluftspalt verschiebbar gelagert ist, ergibt sich eine besonders einfache, flexible Konstruktion. Die Tragseile übernehmen dabei eine Doppelfunktion, auf der einen Seite dienen sie der Führung der Inspektionssonde, auf der anderen Seite verspannen sie aber auch die beiden Endteile der Basiseinheit im Spalt gegeneinander und bewirken so die axiale Fixierung der Basiseinheit am Rotor. Die Ausbildung dieser axialen Fixierung durch Tragseile weist ausserdem den Vorteil auf, dass die Vorrichtung durch Anpassung der Tragseillänge einfach auf verschiedene Generatorlängen angepasst werden kann.

Zudem ist die Basiseinheit auf den Rotorkappen umlaufend beweglich gelagert. Dies insbesondere dadurch, dass die Endteile auf der radial aussenseitigen Zylinderoberfläche der Rotorkappe angeordnet sind und mit um diese aussenseitige Zylinderoberfläche umlaufenden Gurten an den Rotorkappen befestigt sind. Besonders einfach lässt sich dabei eine Anpassung an verschiedene Rotordurchmesser vornehmen, wenn die Gurte aus einzelnen Stücken bestehen, wobei insbesondere an den Verbindungspunkten zwischen den einzelnen Stücken Gurtrollen verwendet werden, welche die Verschiebbarkeit der Basiseinheit auf der Rotorkappe in Umfangsrichtung des Maschinenluftspaltes erleichtern. Die Gurtrollen rollen auf dem Rotorkappenumfang und verhindern, dass die Gurte auf dem Umfang zu viel sich der Rotation der Basiseinheit widersetzende Reibung erzeugen. Die Bewegung der Einheit auf der Rotorkappe wird über auf den Rotorkappen rollenden Bewegungsrollen bewirkt. Schliesslich verfügen die Endteile über einen Anschlag, welcher jeweils an der axial aussenliegenden Stirnseite der Rotorkappen zum Anschlag kommt.

Der Kern der Erfindung besteht somit darin, die Vorrichtung nicht an Stator oder Statorgehäuse zu befestigen, sondern wenigstens mittelbar am Rotor. Infolge der bei unterschiedlichen Generatortypen im wesentlichen gleichen Ausgestaltung der Rotoren ergibt sich daraus direkt der Vorteil, dass an einer derartigen Vorrichtung bei Verwendung an unterschiedlichen Generatoren kaum Anpassungen notwendig sind, und dass infolgedessen die Vorrichtung schnell und einfach angebracht werden kann. Insbesondere bei Generatoren mit besonders engen Platzverhältnissen im Bereich des Wickelkopfes und bei kleinen Generatoren ist die vorgeschlagene Lösung vorteilhaft einsetzbar. Wenn ein derartiger Generator in einer Einwellenanlage eingebaut ist, bei welcher der Generator zwischen einer Dampf- und einer Gasturbine gewissermassen "eingeklemmt" ist, und bei welcher der Ausbau des Rotors erschwert ist, erhöht sich der Nutzen von Inspektionsdienstleistungen bei eingebautem Rotor besonders.

Gemäss einer Ausführungsform der Erfindung ist die wenigstens eine Inspektionssonde an einem Zugseil befestigt, welches Zugseil über an den Endteilen angebrachte Zugrollen derart aufrollbar befestigt ist, dass die Inspektionssonde über synchrone Rotation der beiden Zugrollen in axialer Richtung verschoben werden kann. Weiterhin bevorzugt wird das Zugseil auf beiden Seiten auf den Zugrollen derart aufgerollt, dass die Verwendung der Vorrichtung bei unterschiedlichen Generatorlängen möglich ist. Die Verwendung eines Zugseils erlaubt wiederum auf der einen Seite die einfache Realisierung der Verschiebung der Inspektionssonde, auf der anderen Seite kann so die Vorrichtung aber auch einfach an verschiedene

Generatorlängen angepasst werden ohne mühsames Umfädeln des Zugseils auf den Rollen. Dies dadurch, dass das Zugseil nicht umlaufend ausgebildet ist, sondern auf jeder der Zugrollen aufgerollt.

Eine weitere bevorzugte Ausführungsform ist dadurch gekennzeichnet, dass die Bewegungsrollen konisch ausgestaltet und an den Endteilen derart angeordnet sind, dass die Endteile bei Bewegung auf den Rotorkappen stets die Tendenz haben, sich gegen das Innere des Maschinenluftspaltes zu bewegen, wobei der Anschlag die innengerichtete, infolge der konischen Bewegungsrollen bewirkte Bewegung begrenzt. Auf diese Weise kann einfach und effizient verhindert werden, dass die Vorrichtung auf der Rotorkappe bei umfangsmässiger Rotation der Vorrichtung auf der Kappe dejustiert wird.

Eine weitere bevorzugte Ausführungsform ist dadurch gekennzeichnet, dass in den Endteilen Motoren angeordnet sind, welche die Bewegungsrollen antreiben.

Weitere bevorzugte Ausführungsformen der obigen Vorrichtung ergeben sich gemäss den abhängigen Ansprüchen.

Des weiteren betrifft die Erfindung ein Verfahren zur Untersuchung von an einen Maschinenluftspalt zwischen Stator und Rotor grenzenden Bestandteilen eines Generators bei eingebautem Rotor mittels wenigstens einer beweglichen Inspektionssonde unter Verwendung einer obenbeschriebenen Vorrichtung.

### KURZE ERLÄUTERUNG DER FIGUREN

Die Erfindung soll nachfolgend anhand von Ausführungsbeispielen im Zusammenhang mit den Zeichnungen näher erläutert werden. Es zeigen:
- Fig. 1: einen schematischen Schnitt durch einen Generator mit einer eingebauten Diagnosevorrichtung;
- Fig. 2: einen detaillierten Schnitt durch den endseitigen Bereich bei aufgesetztem Diagnosegerät;
- Fig. 3: eine Ansicht des Diagnosegeräts in axialer Richtung von der Stirnseite des Rotors;
- Fig. 4: die Gurtstücke und Rollen in Auf- (a) und Seitenansicht (b); und
- Fig. 5: eine Aufsicht auf das montierte Diagnosegerät.

### WEGE ZUR AUSFÜHRUNG DER ERFINDUNG

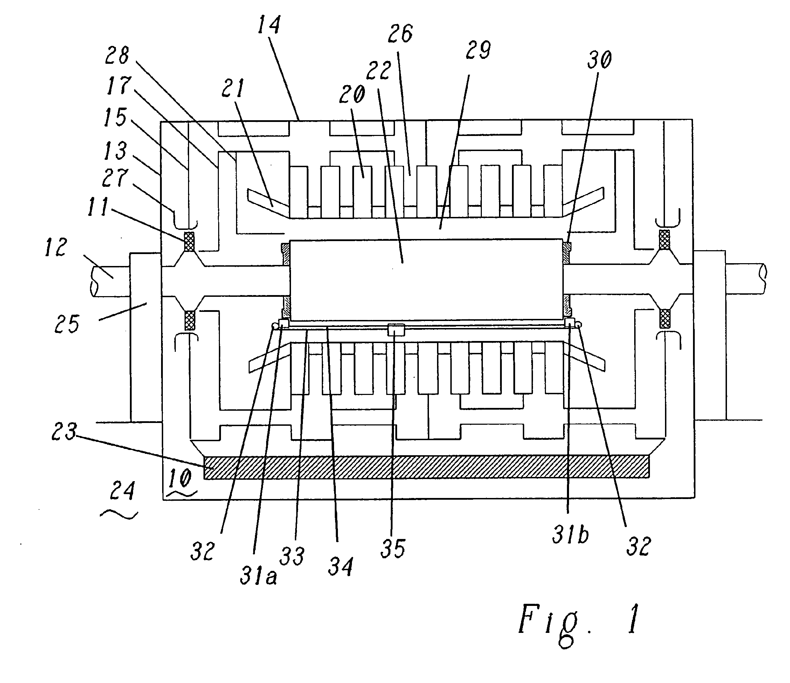

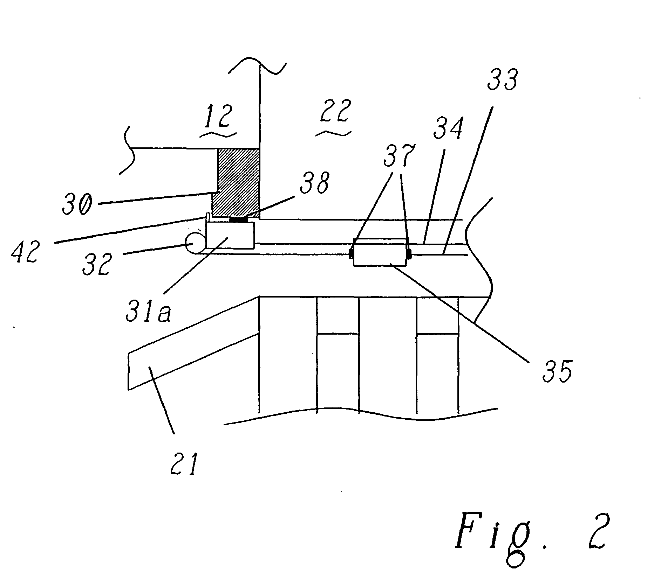

Figur 1 zeigt einen schematischen Längsschnitt durch einen Generator. Es handelt sich beim beispielhaft dargestellten Generator um einen Generator im Saugkühlprinzip, die Verwendung der vorgeschlagenen Vorrichtung ist aber keineswegs auf derartige Generatoren beschränkt. Der Generator ist stirnseitig und rückseitig von Maschinengehäusedeckeln 13 begrenzt und längs von einem zylindrischen Maschinengehäuse 14 umfasst. Das Gehäuse umfasst einen aus Teilblechkörpern 20 gebildeten Statorblechkörper, in welchem radiale Belüftungsschlitze 26 zwischen den verschiedenen Teilblechkörpern 20 vorhanden sind. Ein Rotor 22 befindet sich im Zentrum des Statorblechkörpers und die zugehörige Rotorwelle 12 ist in Bocklagern 25 gelagert, welche auf dem Fundament 24 aufliegen.

Das Fundament 24 weist eine Fundamentgrube 10 auf, die sich axial über die ganze Länge des Maschinengehäuses 24 erstreckt, und in welcher eine Kühlanordnung 23 des Generators angeordnet ist. Dabei stehen die Eintrittsöffnungen der Kühlanordnung 23 mit Ausströmräumen von beiderseits des Rotors 22 angeordneten Hauptventilatoren 11 in Verbindung. Der Hauptventilator 11 ist dabei mit der Rotorwelle 12 fest verbunden und dreht sich mit der gleichen Geschwindigkeit wie der Rotor 22. Zur gezielten Führung der Kühlluftströme durch den Wickelkopf 21 des Stators in den Maschinenluftspalt 29 zwischen Rotor und Stator, sowie in den Rotor 22 sind Leitbleche 28, Innenverschalungen 17, Plattendiffusoren 27 und Aussenverschalungen 15 angeordnet.

In der oberen Hälfte der Figur ist der Generator ohne Modifikation dargestellt, in der unteren Hälfte hingegen ist angedeutet, dass für die Montage der Vorrichtung gewisse Bauteile wie hier das Leitblech 28 ausgebaut werden müssen. Normalerweise müssen die Generatoren vor Montage der Vorrichtung im Fall von wasserstoffgekühlten Modellen gespült werden und Diffusoren, Wicklungsverschalungen und Luftspaltblenden entfernt oder verschoben werden, Lagerschildoberteile müssen ggf. ebenfalls entfernt werden, um den Zugang an den Rotor zu erlauben. Dargestellt ist nun ein Schnitt durch eine im Maschinenluftspalt montierte Diagnosevorrichtung in 6-Uhr-Stellung. Die Vorrichtung besteht aus einer Basiseinheit 31 mit zwei Endteilen 31a und 31b, welche an den Rotorkappen 30 befestigt sind. Zwischen den Endteilen verläuft zunächst wenigstens ein Tragseil 34, welches einerseits dazu dient, die beiden Endteile gegeneinander in axialer Richtung zu verspannen und damit die Vorrichtung am Rotor zu fixieren. Auf der anderen Seite dienen die Tragseile aber auch der verschiebbaren Führung der Inspektionssonde 35 in axialer Richtung. Die Endteile 31a und 31b weisen ausserdem je eine Zugrolle 32 auf, auf welcher ein Zugseil 33 aufgewickelt ist. Am Zugseil 33 ist die Inspektionssonde 35 fest befestigt, und die Sonde wird über synchrones gegenläufiges Drehen der Zugrollen 32a und 32b in axialer Richtung im Maschinenluftspalt 29 verschoben.

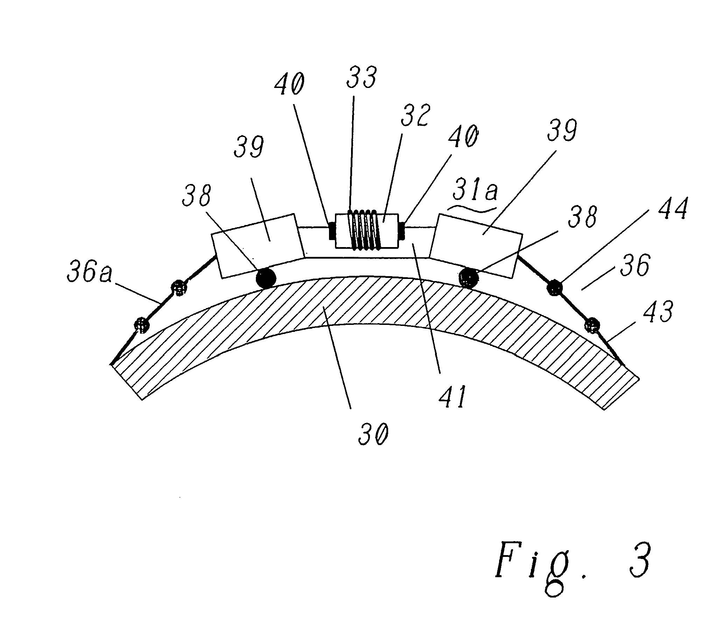

Figur 2 zeigt nun eine Detailansicht eines Schnittes durch das montierte Endteil 31a. Das Endteil liegt auf der Zylinderaussenfläche der Rotorkappe 30 mit Bewegungsrollen 38 auf. Die Bewegungsrollen 38 werden von im Endteil angeordneten Motoren angetrieben und erlauben die Bewegung der ganzen Vorrichtung in Umfangsrichtung des Maschinenluftspaltes in um die Rotorkappe umlaufender Richtung. Damit ist durch die Führung der Sonde an den Tragseilen in Kombination mit der Rotation um die Rotorkappe gewährleistet, dass die Sonde an jeden Ort im Maschinenluftspalt geführt werden kann, und damit die Untersuchung der ganzen Oberfläche von sowohl Stator- als auch Rotoroberfläche ermöglicht wird.

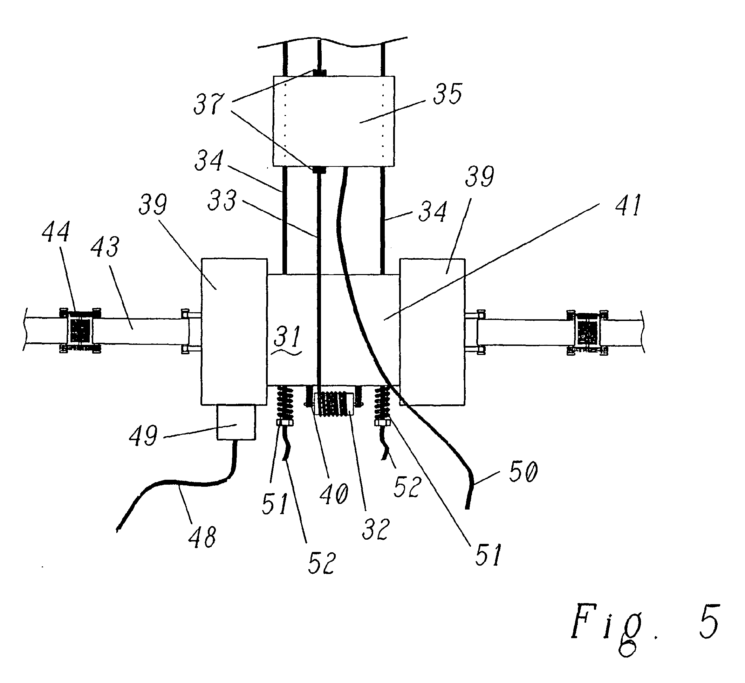

Damit die über Tragseile 34 gegeneinander verspannten Endteile 31a und 31b sich beim rotieren um die Rotorkappe 30 nicht dejustieren, werden die Bewegungsrollen vorzugsweise derart konisch geschnitten, dass das jeweilige Endteil bei Rotation die Tendenz hat, sich gegen das Innere des Spaltes 29 zu verschieben, d.h. sich die Endteile aufeinander zu bewegen. Dies dadurch, dass der axial dem Rotor abgewandte Durchmesser der Bewegungsrolle leicht grösser gehalten wird als der dem Rotor zugewandte. Über einen Anschlag 42, welcher ggf. ebenfalls mit einer kleinen Führungsrolle versehen werden kann, wird die Bewegung der Endteile in Richtung Maschinenluftspaltinneres begrenzt, indem der Anschlag 42 an der axial dem Rotor 22 abgewandten Stirnfläche der Rotorkappe anliegt. So sind die Endteile 31a und 31b relativ zueinander klar und selbststabilisierend fixiert. Um ein Verkeilen der Vorrichtung bei ungleicher Gradstellung der beiden Endteile 31a und 31b zu verhindern, werden, wie unter Figur 5 beschrieben, die Tragseile vorzugsweise in federnder Weise an den Endteilen angeschlagen.

Figur 3 zeigt eine Ansicht auf eine Stirnseite eines Rotors mit montierter Vorrichtung. Wie das nicht sichtbare Endteil 31b wird auch das Endteil 31a über um die Rotorkappe 30 umlaufende Gurte 36 an der Rotorkappe 30 fixiert. Ein Endteil weist dabei zwei seitliche Motorengehäuse 39 auf, in welchen die Motoren für die Bewegungsrollen 38 angeordnet sind, und an welchen die Bewegungsrollen 38 auch gleich selber montiert sind. Zwischen den Motorengehäusen befindet sich ein diese verbindendes Mittelteil 41, an welchem die Zugrolle 32 über Halterungen 40 befestigt ist. Auf der Zugrolle aufgewickelt ist das Zugseil 33, welches der Verschiebung der Inspektionssonde dient. Die Zugrolle 32 wird von einem hier nicht dargestellten Motor gesteuert angetrieben. Das Zugseil 33 ist dabei nicht umlaufend ausgebildet sondern als auf beiden Seiten aufgerolltes Seil, so dass die Inspektion von Generatoren verschiedener Länge möglich ist.

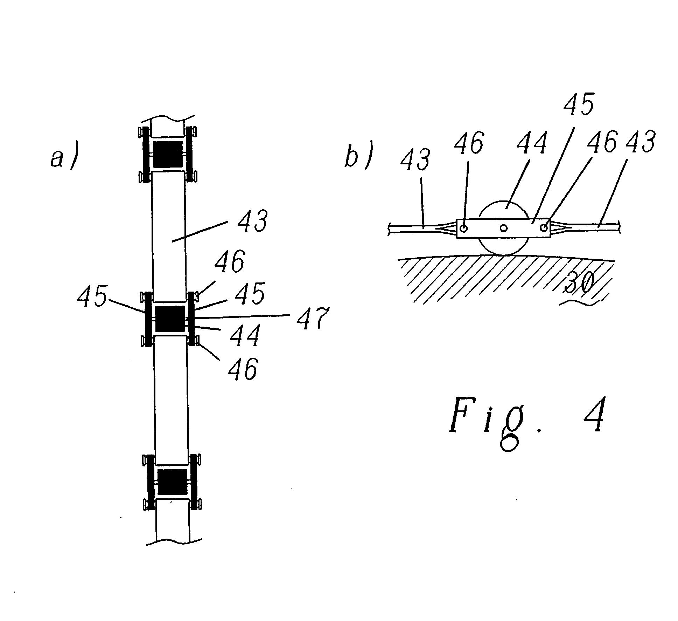

Um die Rotierbarkeit der Endteile um den Rotorumfang unter Vermeidung grosser Reibung auf der Rotorkappe sicherzustellen, sollten die Gurte 36 besonders ausgestaltet sein. Figur 4 zeigt derartige Gurte. Auf der einen Seite bestehen die Gurte aus einzelnen Stücken 43, was eine einfache Anpassbarkeit an verschiedene Rotorkappendurchmesser erlaubt. Auf der anderen Seite sind die einzelnen Stücke 43 über spezielle Verbindungsstücke verbunden, welche dafür sorgen, dass die Gurte 36 gar nicht auf der Rotorkappe 30 aufliegen, sondern nur die als drehbare Gurtrollen ausgebildeten Elemente 44. Die Gurtrollen 44 werden dabei von Seitengliedern 45 gefasst, welche ihrerseits die einzelnen Gurtstücke 43 über Stifte 46 beidseitig fassen. Es ist dabei darauf zu achten, dass die Länge der Gurtstücke 43 und die Durchmesser der Gurtrollen 44 derart aufeinander angepasst sind, dass für alle zu untersuchenden Rotordurchmesser sichergestellt ist, dass die Gurte nicht auf der Rotorkappenoberfläche aufliegen, d.h. die Gurtrollen 44 die Gurtstücke 43 durch ihren Durchmesser genügend von der Oberfläche der Rotorkappenzylinderoberfläche beabstanden.

Figur 5 zeigt eine Aufsicht auf eine montierte Vorrichtung in radialer Richtung von Aussen auf den Rotor. Die Inspektionssonde 35 wird seitlich von zwei Tragseilen 34 verschiebbar geführt. Das Zugseil 33 hingegen ist über Befestigungspunkte 37 fest mit der Sonde 35 verbunden, was die Verschiebung der Sonde 35 axial über die Zugrollen 32 erlaubt, wobei die beiden Rollen der beiden Endteile 31a und 31b synchron arbeiten. Auf der Inspektionssonde 35 können nun verschiedene Inspektionseinheiten fixiert werden, je nach zu untersuchendem Gegenstand. Jede Einheit verfügt vorteilhafterweise über eine Kamera, welche zur Positionierung und Orientierung der Sonde verwendet werden kann, welche aber auch visuell ermittelbare Informationen über den Windungsschluss der Rotorwicklung, die Blechpaketenden, den Zustand der in der Statorbohrung sichtbaren Teile wie z.B. Nutkeile und Blechung, Rotoroberfläche einschliesslich Verkeilung und Kappen etc. zugänglich macht. Andererseits verfügt jede Einheit über eine Ausrüstung jeweils eines Messverfahrens zur Datenermittlung in Bezug auf Statornutverkeilung, Statorblechpaket, Blechkurzschlüsse etc. So beispielsweise zur Bewertung des Zustandes der Statorverkeilung ein System, das mit festgelegter Stärke die Keile abklopft und die resultierenden Schwingungen registriert oder aber ein System zur Ermittlung des Zustands des Statorblechpaketes das auf der Messung des Nut-Streuflusses basiert, welcher sich beim Vorliegen von Kurzschlüssen verändert. Der Nut-Streufluss wird dabei durch Ringmagnetisierung (Niederinduktion) des Blechpaketes erzeugt und durch Aufzeichnen des Streuflussbildes der Blechzähne so eventuelle Kurzschlüsse lokalisiert.

Die Inspektionssonde ist mit einem Datenkabel 50 verbunden, über welches die von den Inspektionseinheiten ermittelten Informationen an eine Datenverarbeitungsanlage ausserhalb des Generators übermittelt werden.

Wie bereits weiter oben dargelegt, werden die Tragseile 34 bevorzugt gefedert an den Endteilen gelagert, damit sich die Vorrichtung nicht verkeilen kann. Dazu sind Rückfederungen 51 vorgesehen, idealerweise so, dass die Tragseile 34 beliebig lang sein können und ein Überschuss 52 der Seile 34 hinausragen kann, und der Federungsmechanismus jeweils für eine bestimmte Rotorlänge justiert werden kann.

Jedes Endteil 31 verfügt ausserdem über eine Elektronikeinheit 49, welche über ein Steuerkabel 48 mit derselben Datenverarbeitungsanlage wie oben erwähnt verbunden ist, d.h. eine Datenverarbeitungsanlage steuert die beiden Endteile und erfasst gleichzeitig die Daten aus der Inspektionseinheit. Die Elektronikeinheit 49 dient der Steuerung der Bewegungsrollen 38 und der Steuerung der Zugrolle 32, sowie ggf. weiterer Steuerungen auf dem jeweiligen Endteil.

### BEZEICHNUNGSLISTE

- 10: Fundamentgrube
- 11: Hauptventilator
- 12: Rotorwelle
- 13: Maschinengehäusedeckel
- 14: zylindrisches Maschinengehäuse
- 15: Aussenverschalung
- 17: Innenverschalung
- 20: Teilblechkörper
- 21: Wickelkopf
- 22: Rotor
- 23: Kühlanordnung
- 24: Fundament
- 25: Bocklager
- 26: Belüftungsschlitze
- 27: Plattendiffusor
- 28: Leitblech
- 29: Maschinenluftspalt
- 30: Rotorkappe
- 31: Basiseinheit
- 31a,b: Endteile von 31
- 32: Zugrolle
- 33: Zugseil
- 34: Tragseil
- 35: Inspektionssonde
- 36: Gurt
- 37: Befestigungspunkte für Zugseil
- 38: Bewegungsrolle
- 39: Motorengehäuse für 38
- 40: Halterung von 32
- 41: Mittelteil
- 42: Anschlag
- 43: Gurtstück
- 44: Gurtrolle
- 45: Seitenglied
- 46: Stift für Gurtstück
- 47: Achse von Gurtrolle
- 48: Steuerkabel
- 49: Elektronikeinheit
- 50: Datenkabel für Inspektionssonde
- 51: Rückfederung für 34
- 52: Überschuss von 34

## Patentansprüche

1. Vorrichtung zur Untersuchung von an einen Maschinenluftspalt (29) zwischen Stator und Rotor (22) grenzenden Bestandteilen eines Generators bei eingebautem Rotor (22) mittels wenigstens einer beweglichen Inspektionssonde (35), wobei
a) die Vorrichtung eine Basiseinheit (31) umfasst, welche an endseitig am Rotor (22) angebrachten Rotorkappen (30) befestigt wird ,
b) die Basiseinheit es erlaubt, die wenigstens eine Inspektionssonde (35) im Maschinenluftspalt (29) sowohl in bezüglich der Generatorachse axialer als auch in Umfangsrichtung des Maschinenluftspaltes (29) über den vollen Umfang des Rotors zu bewegen,
c) die Basiseinheit (31) zwei Endteile (31 a,31 b) umfasst, welche an den Rotorkappen (30) befestigt werden, und wobei zwischen den Endteilen (31a,31b) wenigstens ein, vorzugsweise aber zwei Tragseile (34) angeordnet sind, an welchen die wenigstens eine Inspektionssonde (35) in axialer Richtung im Maschinenluftspalt (29) verschiebbar gelagert ist.
d) die Endteile (31 a,31 b) der Basiseinheit (31) auf den Rotorkappen (30) umlaufend beweglich gelagert sind,
e) die Endteile (31 a,31 b) auf der radial aussenseitigen Zylinderoberfläche der Rotorkappe (30) angeordnet sind und mit um diese aussenseitige Zylinderoberfläche umlaufenden Gurten (36) an den Rotorkappen (30) befestigt sind,
**dadurch gekennzeichnet, dass**
f) die Gurte (36) aus einzelnen Stücken (43) bestehen, die es erlauben, eine Anpassung an verschiedene Rotordurchmesser vorzunehmen, und an den Verbindungspunkten zwischen den einzelnen Stücken (43) über Gurtrollen (44) verfügen, welche die Verschiebbarkeit der Basiseinheit auf den Rotorkappen (30) in Umfangsrichtung des Maschinenluftspaltes (29) erleichtern,
g) die Bewegung der Basiseinheit (31) auf den Rotorkappen (30) über auf den Rotorkappen (30) rollenden Bewegungsrollen (38) bewirkt wird, und
h) die Endteile (31 a,31 b) über einen Anschlag (42) verfügen, welcher jeweils an der axial aussenliegenden Stirnseite der Rotorkappen (30) zum Anschlag kommt.

2. Vorrichtung nach Anspruch 1, **dadurch gekennzeichnet, dass** die wenigstens eine Inspektionssonde (35) an einem Zugseil (33) befestigt ist, welches Zugseil (33) über an den Endteilen (31 a,31 b) angebrachte Zugrollen (32) derart aufrollbar befestigt ist, dass die Inspektionssonde (35) über synchrone Rotation der beiden Zugrollen (32) in axialer Richtung verschiebbar ist.

3. Vorrichtung nach Anspruch 2, **dadurch gekennzeichnet, dass** das Zugseil (33) auf beiden Seiten auf den Zugrollen (32) derart aufgerollt ist, dass die Verwendung der Vorrichtung bei unterschiedlichen Generatorlängen möglich ist.

4. Vorrichtung nach einem der Ansprüche 1 bis 3, **dadurch gekennzeichnet, dass** in den Endteilen (31 a,31 b) die Bewegungsrollen (38) antreibende Motoren angeordnet sind.

5. Vorrichtung nach Anspruch 4, **dadurch gekennzeichnet, dass** die Bewegungsrollen (38) konisch ausgestaltet und an den Endteilen (31 a,31 b) derart angeordnet sind, dass die Endteile (31 a,31 b) bei Bewegung auf den Rotorkappen (30) stets die Tendenz haben, sich gegen das Innere des Maschinenluftspaltes (29) zu bewegen und wobei der Anschlag (42) die innengerichtete, infolge der konischen Bewegungsrollen (38) bewirkte Bewegung begrenzt.

6. Vorrichtung nach einem der vorhergehenden Ansprüche, **dadurch gekennzeichnet, dass** die Inspektionssonde (35) seitlich von zwei Tragseilen (34) geführt wird und mit verschiedenen Inspektionseinheiten bestückt werden kann, welche jeweils über eine Kamera zur visuellen Inspektion des Generators und zur Positionierung der Inspektionssonde (35) verfügen, wobei insbesondere eine derartige Inspektionseinheit zusätzlich mit Mitteln zur Untersuchung der Statornutverkeilung ausgerüstet ist, oder zusätzlich mit Mitteln zur Untersuchung des Statorblechpaketes ausgerüstet ist.

7. Verfahren zur Untersuchung von an einen Maschinenluftspalt (29) zwischen Stator und Rotor (22) grenzenden Bestandteilen eines Generators bei eingebautem Rotor (22) mittels wenigstens einer beweglichen Inspektionssonde (35) unter Verwendung einer Vorrichtung nach einem der Ansprüche 1 bis 6.

## Claims

1. Device for the investigation of components of a generator which are adjacent to a machine air gap (29) between a stator and rotor (22), in the case of an installed rotor (22), by means of at least one movable inspection probe (35),
a) the device comprising a base unit (31) which is fastened to rotor caps (30) mounted on the rotor (22) on the end faces,
b) the base unit making it possible to move the at least one inspection probe (35) in the machine air gap (29) over the entire circumference of the rotor both axially with respect to the generator axis and in the circumferential direction of the machine air gap (29),
c) the base unit (31) comprising two end parts (31a, 31b) which are fastened to the rotor caps (30), and the end parts (31a, 31b) having arranged between them at least one, but preferably two carrying ropes (34), on which the at least one inspection probe (35) is mounted displaceably in the axial direction in the machine air gap (29),
d) the end parts (31a, 31b) of the base unit (31) being mounted continuously movably on the rotor caps (30),
e) the end parts (31a, 31b) being arranged on the radially outer cylinder surface of the rotor cap (30) and being fastened to the rotor caps (30) by means of belts (36) running around this outer cylinder surface,
**characterized in that**
f) the belts (36) consist of individual pieces (43) which make it possible to carry out an adaptation to different rotor diameters and which have at the connection points between the individual pieces (43) belt rollers (44) which facilitate the displaceability of the base unit on the rotor caps (30) in the circumferential direction of the machine air gap (29),
g) the movement of the base unit (31) on the rotor caps (30) is brought about by movement rollers (38) rolling on the rotor caps (30), and
h) the end parts (31a, 31b) have an abutment (42) which in each case comes into abutment against the axially outer end face of the rotor caps (30).

2. Device according to Claim 1, **characterized in that** the at least one inspection probe (35) is fastened to a traction rope (33) which is fastened so as to be capable of being rolled up via traction rollers (32) mounted on the end parts (31a, 31b), in such a way that the inspection probe (35) can be displaced in the axial direction via the synchronous rotation of the two traction rollers (32).

3. Device according to Claim 2, **characterized in that** the traction rope (33) is rolled up on the traction rollers (32) on both sides in such a way that it is possible to use the device in the case of different generator lengths.

4. Device according to one of Claims 1 to 3, **characterized in that** motors driving the movement rollers (38) are arranged in the end parts (31a, 31b).

5. Device according to Claim 4, **characterized in that** the movement rollers (38) are designed conically and are arranged on the end parts (31a, 31b) in such a way that, during movement on the rotor caps (30), the end parts (31a, 31b) always tend to move towards the interior of the machine air gap (29), the abutment (42) limiting the inwardly directed movement brought about as a result of the conical movement rollers (38).

6. Device according to one of the preceding claims, **characterized in that** the inspection probe (35) is guided laterally by two carrying ropes (34) and can be equipped with various inspection units which in each case have a camera for the visual inspection of the generator and for positioning the inspection probe (35), in particular an inspection unit of this type being equipped additionally with means for investigating the stator keying or being equipped additionally with means for investigating the stator laminated core.

7. Method for an investigation of components of a generator which are adjacent to a machine air gap (29) between a stator and rotor (22), in the case of an installed rotor (22), by means of at least one movable inspection probe (35), using a device according to one of Claims 1 to 6.

## Revendications

1. Dispositif pour examiner les composants d'un générateur délimitant un entrefer de machine (29) entre le stator et le rotor (22) avec le rotor (22) monté au moyen d'au moins une sonde d'inspection mobile (35),
a) le dispositif comprenant une unité de base (31) qui est fixée du côté de l'extrémité sur les chapeaux de rotor (30) montés sur le rotor (22),
b) l'unité de base permettant de déplacer l'au moins une sonde d'inspection (35) dans l'entrefer de machine (29) sur tout le pourtour du rotor aussi bien dans le sens axial par rapport à l'axe du générateur que dans le sens du pourtour de l'entrefer de machine (29),
c) l'unité de base (31) comprenant deux pièces d'extrémité (31a, 31b) qui sont fixées sur les chapeaux de rotor (30) et au moins un, mais de préférence deux câbles porteurs (34) étant disposés entre les pièces d'extrémité (31a, 31b), sur lesquels l'au moins une sonde d'inspection (35) est montée de manière à pouvoir coulisser dans le sens axial dans l'entrefer de machine (29),
d) les pièces d'extrémité (31a, 31b) de l'unité de base (31) étant montées sur les chapeaux de rotor (30) de manière à pouvoir se déplacer dans le sens du pourtour,
e) les pièces d'extrémité (31a, 31b) étant disposées sur la surface cylindrique extérieure radiale du chapeau de rotor (30) et étant fixées sur les chapeaux de rotor (30) avec des sangles (36) qui font le tour de cette surface cylindrique extérieure,
**caractérisé en ce que**
f) les sangles (36) se composent d'éléments individuels (43) qui permettent une adaptation à différents diamètres de rotor, et disposant au niveau des points de liaison entre les éléments individuels (43) de rouleaux de sangle (44) qui facilitent l'aptitude à la translation de l'unité de base sur les chapeaux de rotor (30) dans le sens du pourtour de l'entrefer de machine (29),
g) le mouvement de l'unité de base (31) sur les chapeaux de rotor (30) est réalisé par le biais de rouleaux de déplacement (38) qui roulent sur les chapeaux de rotor (30), et
h) les pièces d'extrémité (31a, 31b) disposent d'une butée (42) qui vient à chaque fois en butée contre le côté frontal extérieur axial des chapeaux de rotor (30).

2. Dispositif selon la revendication 1, **caractérisé en ce que** l'au moins une sonde d'inspection (35) est fixée à un câble de traction (33), lequel câble de traction (33) est fixé de manière enroulable par le biais de rouleaux de traction (32) montés sur les pièces d'extrémité (31a, 31b) de telle sorte que la sonde d'inspection (35) puisse être déplacée par une rotation synchrone des deux rouleaux de traction (32) dans le sens axial.

3. Dispositif selon la revendication 2, **caractérisé en ce que** le câble de traction (33) est enroulé des deux côtés sur les rouleaux de traction (32) de sorte qu'il soit possible d'utiliser le dispositif avec des longueurs de générateur différentes.

4. Dispositif selon l'une des revendications 1 à 3, **caractérisé en ce que** des moteurs d'entraînement des rouleaux de déplacement (38) sont disposés dans les pièces d'extrémité (31a, 31b).

5. Dispositif selon la revendication 4, **caractérisé en ce que** les rouleaux de déplacement (38) sont de forme conique et disposés au niveau des pièces d'extrémité (31a, 31b) de telle sorte que les pièces d'extrémité (31a, 31b), lors du mouvement sur les chapeaux de rotor (30), ont toujours tendance à se déplacer vers l'intérieur de l'entrefer de machine (29), la butée (42) limitant le mouvement dirigé vers l'intérieur et provoqué par les rouleaux de déplacement coniques (38).

6. Dispositif selon l'une des revendications précédentes, **caractérisé en ce que** la sonde d'inspection (35) est guidée latéralement par deux câbles porteurs (34) et peut être équipée de différentes unités d'inspection, lesquelles disposent à chaque fois d'une caméra pour l'inspection visuelle du générateur et pour le positionnement de la sonde d'inspection (35), une unité d'inspection de ce type étant notamment en plus équipée de moyens pour examiner l'habillage du stator ou étant en plus équipée de moyens pour examiner le noyau en tôles du stator.

7. Procédé pour examiner les composants d'un générateur délimitant un entrefer de machine (29) entre le stator et le rotor (22) avec le rotor (22) monté au moyen d'au moins une sonde d'inspection mobile (35) en utilisant un dispositif selon l'une des revendications 1 à 6.
